## Europäisches Patentamt
## European Patent Office
## Office européen des brevets

(19)

(11) Veröffentlichungsnummer: **0 111 826**
**B1**

(12) # EUROPÄISCHE PATENTSCHRIFT

(45) Veröffentlichungstag der Patentschrift:
**08.04.87**

(51) Int. Cl.⁴: **G 01 R 33/035**

(21) Anmeldenummer: **83112269.2**

(22) Anmeldetag: **06.12.83**

(54) **Mehrkanalige Vorrichtung zur Messung von verschiedenen Feldquellen hervorgerufener schwacher Magnetfelder.**

(30) Priorität: **22.12.82 DE 3247585**

(43) Veröffentlichungstag der Anmeldung:
**27.06.84 Patentblatt 84/26**

(45) Bekanntmachung des Hinweises auf die Patenterteilung:
**08.04.87 Patentblatt 87/15**

(84) Benannte Vertragsstaaten:
**DE FR IT**

(56) Entgegenhaltungen:
**IEEE TRANSACTIONS ON BIOMEDICAL ENGINEERING, Band BME-29, Nr. 1, Januar 1982, Seiten 16-25, New York, US; T. KATILA et al.: "Magnetic measurement of cardiac volume changes"**

(73) Patentinhaber: **Siemens Aktiengesellschaft Berlin und München, Wittelsbacherplatz 2, D-8000 München 2 (DE)**

(72) Erfinder: **Hoenig, Eckhardt, Dr., Palmstrasse 1a, D-8520 Erlangen (DE)**

## Beschreibung

Die Erfindung bezieht sich auf eine mehrkanalige Vorrichtung zur Messung von verschiedenen Feldquellen hervorgerufener, sich ändernder Magnetfelder mit Feldstärken unter $10^{-10}$ T, insbesondere unter $10^{-12}$ T, wobei die Meßvorrichtung in jedem Kanal ein supraleitendes Quanten-Interferenz-Element (SQUID), ein durch supraleitende Spulen vorbestimmter Abmessungen gebildetes Gradiometer sowie supraleitende Verknüpfungsglieder zwischen dem Quanten-Interferenz- Element und dem Gradiometer enthält, und welche ferner mit elektronischen Einrichtungen zur Auswertung, Verarbeitung und Darstellung der an den Quanten-Interferenz-Elementen gewonnenen Informationen versehen ist.

Die Verwendung von supraleitenden Quanten-Interferenz-Elementen, die allgemein als "SQUIDs" (Abkürzung von "Superconducting QUantum Interference Devices") bezeichnet werden, zur Messung sehr schwacher magnetischer Felder ist allgemein bekannt ("J.Phy.E:Sci. Instrum.", Vol. 13, 1980, Seiten 801 bis 813; "IEEE Transactions on Electron Devices", Vol.ED-27, No. 10, Oktober 1980, Seiten 1896 bis 1908). Als ein bevorzugtes Anwendungsgebiet für diese Elemente wird deshalb auch die medizinische Technik, insbesondere die Magnetokardiographie und Magnetoenzephalographie angesehen. Die auf diesen Gebieten auftretenden magnetischen Herz- bzw. Gehirnwellen weisen Feldstärken auf, die in der Größenordnung von 50 pT bzw. 0,1pT liegen ("Biomagnetism - Proceedings Third International Workshop on Biomagnetism, Eerlin 1980", Berlin/New York 1981, Seiten 3 bis 31).

Eine Vorrichtung zur Messung derartiger biomagnetischer Felder enthält im wesentlichen folgende Komponenten:

1. Ein SQUID als den eigentlichen Feld-Sensor,
2. einen Flußtransformator mit einer Spulenanordnung zur Einkopplung des zu untersuchenden Feldes,
3. elektronische Geräte zur Signalerfassung, -verarbeitung und -ausgabe,
4. Abschirmungen für das magnetische Erdfeld und externe Störfelder und
5. ein Kryosystem für den Tieftemperaturbereich der Supraleitung.

Derartige Meßvorrichtungen sind allgemein bekannt (z.b. firma S.H.E. Corporation, San Diego, USA/S.H.E. GmbH, D-5100 Aachen).

Bei entsprechenden einkanalig ausgebildeten Meßvorrichtungen wird das zu untersuchende Magnetfeld über eine Spulenanordnung aus supraleitendem Draht in den von einem Radiofrequenz (RF)-SQUID gebildeten Kreis mit einem Josephson-Kontakt induktiv eingekoppelt. Dabei sind durch Kombination einer Sensorspule mit einer oder mehreren Kompensationsspulen Gradiometer erster bzw. höherer Ordnung ausgebildet. Mit solchen Gradiometern können bei entsprechendem manuellen Abgleich die drei Komponenten eines im Spulenbereich homogenen Magnetfeldes bzw. auch dessen Anteil mit homogenem Gradienten weitgehend unterdrückt und das im Gradiometerbereich noch stark inhomogene biomagnetische Nahfeld selektiv erfaßt werden. Das RF-SQUID ist außerdem mit einem Resonanzschwingkreis induktiv gekoppelt, dessen hochfrequente Spannung in Phase oder Amplitude durch das Eingangssignal moduliert wird. Im allgemeinen wird durch negative Rückkopplung über eine zusätzliche Kompensationsspule der Arbeitspunkt des RF-SQUID festgehalten und der Kompensationsstrom als elektronisch auszuwertendes Signal verwendet.

Ausgehend von dieser bekannten einkanaligen Meßvorrichtung sind auch mehrkanalige Vorrichtungen vorgeschlagen worden. Hierbei weist jeder Kanal neben einem SQUID ein supraleitendes Gradiometer und Verknüpfungsglieder zwischen dem SQUID und dem Gradiometer mit einem Koppeltransformator und Verbindungsleitern auf.

Mit den Gradiometer-Spulen läßt Sich der Fluß des Feldvektors einer zu betrachtenden Feldquelle wie z.B. der als "Scheindipol des Herzens" ansehhare Herzvektor in einer vorbestimmten Entfernung ermitteln ("Journal of Magnetism and Magnetic Materials", Vol. 22, 1952, No. 2, Seiten 129 bis 201). Dieser Feldvektor ist jedoch entfernungsabhängig. Durch eine Anpassung der Abmessungen der Gradiometer-Spulen an die jeweilige Entfernung von der Feldquelle läßt sich eine Optimierung der Empfindlichkeit vornehmen, d.h. für eine vorbestimmte Entfernung zwischen einer Feldquelle und einer Gradiometer-Spule ergeben sich bestimmte optimale Abmessungen dieser Gradiometer-Spule.

Das untersuchungsobjekt der magnetischen Herzdiagnostik mit einer Fläche von etwa 100 cm² liegt jedoch nicht in einer einzigen Tiefe, sondern in einem Tiefenbereich von 2 bis 10 cm unter der Thoraxwand, wobei zudem noch seine Lage und Abmessungen periodisch schwanken. Die praktischen Probleme entstehen folglich dadurch, daß eine Gradiometer-Spule an der Thoraxoberfläche mit einer vorgegebenen Abmessung, z.B. mit einem festen Durchmesser von 3 cm, hauptsächlich nur das Nahfeld eines kleinen Bereiches der Herzvorderwand, jedoch kaum des Fernfeld tieferliegender Gebiete erfassen kann. Auch mit den für magnetoenzephalographische Untersuchungen verwendeten Gradiometer-Spulen von etwa 2 cm Durchmesser, die für Messungen von Feldquellen in der Hirnrinde optimal sind, können Messungen von Quellen im Hirnstamm kaum vorgenommen werden, da für solche Messungen der optimale Gradiometer-Spulendurchmesser etwa 10 cm betragen würde. Eine Anpassung der Spulenabmessungen an die jeweilige Entfernung der zu untersuchenden Feldquelle ist bei diesen bekannten Vorrichtungen praktisch nicht möglich.

Eine mehrkanalige Meßvorrichtung für schwache, sich ändernde Magnetfelder wird in der zeitgleichen EP-A- 0 111 827 (veröffentlicht am 27.6.1984) beschrieben.

Aufgabe der vorliegenden Erfindung ist es, die eingangs genannte Meßvorrichtung dahingehend auszugestalten, daß die genannten Schwierigkeiten weitgehend vermieden werden, d.h. daß eine Erhöhung der Empfindlichkeit durch eine Berücksichtigung der Entfernung zwischen Feldquelle und Gradiometer-Spule möglich ist.

Diese Aufgabe wird erfindungsgemäß dadurch gelöst, daß die Abmessungen der einzelnen Gradiometer-Spulen der Entfernung der nächstliegenden Magnetfeldquelle angepaßt sind und daß Mittel zur Zusammenfassung der Signale einzelner vorbestimmter Gradiometer-Spulen zu einem gemeinsamen Signal einer entsprechenden Gruppe von Gradiometer-Spulen in Abhängigkeit von der Entfernung der jeweils zu detektierenden Magnetfeldquelle vorgesehen sind.

Die Anpassung der Abmessungen der Gradiometer-Spulen wird dabei in bekannter Weise so vorgenommen, daß die Ortsauflösung bei dem vorgegebenen Abstand zwischen der detektierenden Gradiometer-Spule und der nächstliegenden magnetfelderzeugenden Quelle optimiert ist (vgl. z.B. die genannte Veröffentlichung aus "Journal of Magnetism and Magnetic Materials"). Je nach dem ob nahe oder ferne Quellen zu registrieren sind, werden die Signale einzelner Gradiometer-Spulen oder zusammengefaßten Signale mehrerer Gradiometer-Spulen zur Auswertung gebracht. Die Vorteile der erfindungsgemäßen Ausgestaltung der Meßvorrichtung sind dann darin zu sehen, daß sich auf diese Weise der effektive Durchmesser einer Gradiometer-Spule optimal an das Meßproblem anpassen läßt.

Besonders vorteilhaft können zur Zusammenfassung der Signale einzelner Gradiometer-Spulen die entsprechenden Kanäle in der elektronischen Einrichtung zur Auswertung und Verarbeitung der an den Quanten-Interferenz-Elementen gewonnenen Informationen zusammengeschaltet sein.

Vorteilhafte Ausgestaltungen der Meßvorrichtung nach der Erfindung gehen auch aus den restlichen Unteransprüchen hervor.

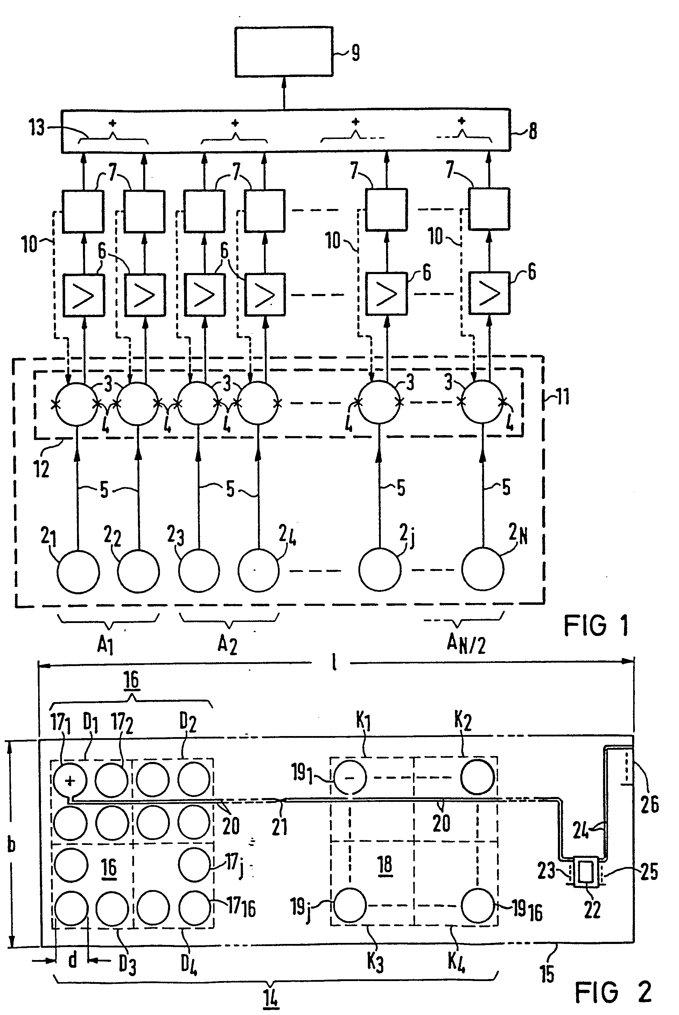

Zur weiteren Erläuterung der Erfindung und deren in den Unteransprüchen gekennzeichneten Weiterbildungen wird auf die Zeichnung Bezug genommen, in deren Figur 1 ein Schaltungsschema einer Meßvorrichtung nach der Erfindung angedeutet ist. Figur 2 zeigt schematisch eine Trägerstruktur dieser Vorrichtung mit SQUIDs und Gradiometern.

Gemäß dem in Figur 1 angedeuteten Schaltungsschema einer Meßvorrichtung nach der Erfindung ist eine vorbestimmte Anzahl N paralleler Meßkanäle vorgesehen. Jeder Kanal enthält dabei ein supraleitendes Gradiometer $2_{j>1}$ (mit $1 \leq j \leq N$), ein Quanten-Interferenz-Element 3, das vorzugsweise ein Gleichstrom-Element (DC-SQUID) mit 2 Josephson-Kontakten 4 ist, ein supraleitendes Verknüpfungsglied 5 zur Verbindung des Gradiometers $2_j$ mit dem SQUID 3, ferner einen beispielsweise ebenfalls zu kühlenden Vorverstärker 6 sowie einen sogenannten "Lock-in"-Verstärker 7 auf z.B. Raumtemperatur.

Die aus den Lock-in-Verstärkern 7 entnommenen N Rohsignale werden dann einem gemeinsamen elektronischen Datenverarbeitungs- und Steuerungssystem 8 zur Weiterverarbeitung und einer Ausgabeeinheit 9 zur Darstellung zugeführt. Eine Rückkopplung in den Kanälen an die jeweiligen SQUIDs mit den den Lock-in-Verstärkern 7 entnommenen Signalen ist durch gepunktete Linien 10 angedeutet. Die Signalübertragungsrichtungen sind in der Figur durch Pfeile an den entsprechenden Linien veranschaulicht.

Wie ferner in der Figur durch gestrichelte Linien angedeutet sein soll, können die Gradiometer $2_j$, die SQUIDs 3 sowie die zwischen ihnen erforderlichen Verbindungsglieder 5 auf einer gemeinsamen, starren Trägerstruktur angeordnet sein. Diese Trägerstruktur ist in der Figur durch eine mit 11 bezeichnete Linie angedeutet. In entsprechender Weise ist ferner veranschaulicht, daß sich die SQUIDs 3 mit ihnen zugeordneten Transformatoren auf einem Trägerplättchen (Chip) 12 befinden, das fest auf der Trägerstruktur 11 angeordnet ist. Die Gradiometer-Spulen $2_j$ können vorteilhaft mit den zwischen ihnen und zu den auf dem Trägerplättchen 12 befindlichen DC-SQUIDs verlaufenden Verbindungsleitern 5 in einer Planarlithographie-Technik als Dünnfilm-Strukturen auf der Trägerstruktur 11 aufgebracht sein, während die SQUIDs 3 auf dem Chip 12 entsprechend einer Technik zur Herstellung integrierter Schaltungen (IC-Technik) ausgebildet sein können.

Um für eine Optimierung der Ortsauflösung der Meßvorrichtung den Durchmesser der Gradiometer-Spulen der Quellentiefe, d.h. dem Abstand zwischen der jeweiligen Spule und einer zu detektierenden Feldquelle anpassen zu können, ist gemäß der Erfindung vorgesehen, daß sich die an den einzelnen Gradiometer-Spulen $2_j$ erzeugten Signale in vorbestimmter Weise zusammenfassen lassen. Dementsprechend kann gemäß dem in der Figur angenommenen Ausführungsbeispiel eine Zusammenfassung der Signale der durch die Gradiometer-Spulen $2_1$ und $2_2$; $2_3$ und $2_4$; usw. gebildeten Gradiometer- Spulengruppen $A_1$ bis $A_{N/2}$ vorgenommen werden, wobei N als gerade Zahl vorausgesetzt wurde. Die Signalzusammenfassung erfolgt dabei vorzugsweise im Bereich der für alle Gruppen gemeinsamen Elektronik 8 durch entsprechende Verknüpfungsschaltungen, die in der Figur durch geschwungene Klammern 13 veranschaulicht sein sollen. Neben der in dem Ausführungsbeispiel gezeigten Zusammenschaltung der Signale einzelner Kanäle durch eine Zusammenfassung der Analogsignale an den Ausgängen der Lock-in-Verstärker 7 sind zur Anpassung an die jeweilige Quellentiefe selbstverständlich auch andere Zusammenschaltungen möglich. So können auch bereits gewandelte, zugeordnete Digitalsignale zusammengefaßt werden.

Die einfachste Anordnung von Feldsensoren ist eine Reihe von Gradiometern nullter Ordnung, d.h. eine ebene Anordnung nebeneinanderliegender, flacher Zylinderspulen aus supraleitendem Draht. Für Messungen mit einer solchen Reihe ohne zusätzliche Kompensation von Fremdfeldern ist zwar eine verhältnismäßig aufwendige Abschirmung erforderlich, jedoch läßt sich eine derartige Gradiometer-Reihe verhältnismäßig einfach herstellen. Geringere Anforderungen hinsichtlich der Abschirmung stellen Gradiometer erster Ordnung. Nähere Einzelheiten eines Ausführungsbeispiels mit einer entsprechenden Gradiometer-Anordnung auf einer gemeinsamen Trägerstruktur sind in der in Figur 2 gezeigten Aufsicht angedeutet.

Die gezeigte Gradiometer-Reihe 14, auch Gradiometer-Feld (Array) genannt, ist planar gestaltet, indem sie auf einer ebenen Trägerstruktur, beispielsweise einer Siliziumplatte 15 von etwa 10 mm Dicke, 12 cm Breite b und 30 cm Länge 1 aufgebracht ist. Die Gradiometer-Reihe wird durch eine Reihe 16 von Detektionsspulen $17_j$, durch eine Reihe 18 mit einer entsprechenden Anzahl von Kompensationsspulen $19_j$ sowie durch entsprechende Verbindungsleitungen 20 gebildet, wobei $1 \leq j \leq N$. Gemäß dem dargestellten Ausführungsbeispiel ist für die Anzahl N der Kanäle 16 gewählt, d.h. jede der Reihen 16 und 18 besteht beispielsweise aus 4 mal 4 einzelnen supraleitenden Flachspulen mit jeweils einer Windung. Da, wie in der Figur ferner durch ein "+"- und "-"-Zeichen angedeutet, der Wickelsinn der Detektionsspulen $17_j$ entgegengesetzt zu dem Wickelsinn der Kompensationsspule $19_j$ ist, muß zwischen den Flachspulenreihen 16 und 18 in den zwischen ihnen liegenden Verbindungsleitungen 20 jeweils ein Überkreuzungspunkt 21 ausgebildet sein.

Neben der in Figur 2 gezeigten Anordnung der Detektionsspulen $17_j$ bezüglich der Kompensationsspulen $19_j$ läßt sich auch eine andere Lage der einzelnen Spulen vorsehen. So können beispielsweise bei einer äußeren Kompensation die Detektionsspulen von einem Kranz aus einzelnen Kompensationsspulen umschlossen sein.

Das Kompensations-Flachspulenfeld 18 kann vorteilhaft auch durch ein kleineres Feld von Spulen mit entsprechend erhöhter Windungszahl ersetzt werden. Dies läßt sich beispielsweise durch ein Lithographie-Verfahren mit Hilfe einer isolierenden Zwischenschicht realisieren.

Auf dem plattenförmigen Träger 15 befindet sich darüber hinaus ein Plättchen (Chip) 22 mit einer der Gradiometer-Anzahl N entsprechenden Anzahl von DC-SQUIDs einschließlich supraleitender Koppeltransformatoren und Modulationsspulen mit Anschlüssen. An Anschlußpunkten 23 sind an diese Koppeltransformatoren die jeweiligen Verbindungsleitungen 20 zur Zuführung der in den Gradiometer-Spulen registrierten Feldsignale supraleitend angeschlossen.

Die an den einzelnen SQUIDs abgenommenen Signale werden dann über normalleitende Eingangs-/Ausgangs-Leitungen 24, die an entsprechenden Anschlußpunkten 25 mit dem DC-SQUID-Chip 22 verbunden sind, einem Vielfach-Kontaktstreifen 26 zugeführt, an dem dann die Verstärker der jeweiligen Kanäle angeschlossen sind.

Erfindungsgemäß sollen die Abmessungen jeder der Flachspulen $17_j$ bzw. $19_j$, bei runder Gestalt der Durchmesser d, dem Abstand zu der nächstliegenden, zu detektierenden Magnetfeldquelle hinsichtlich optimaler Ortsauflösung angepaßt sein. So wählt man z.B. für magnetoenzephalographische Untersuchungen im allgemeinen einen Durchmesser d der Detektionsspulen $17_j$ von etwa 2 cm, der für die Messungen von Quellen in der Hirnrinde optimal ist. Um auch eine Anpassung an tieferliegende Magnetfeldquellen zu ermöglichen, werden erfindungsgemäß durch eine geeignete Zusammenfassung der Signale einzelner Gradiometer-Spulen Spulenverhältnisse eingestellt, die weitgehend effektiven Spulenabmessungen entsprechen, die für die größeren Entfernungen zwischen Magnetfeldquelle und Spule optimal sind. So können z.B. jeweils vier der Detektionsspulen $17_j$ und in entsprechender Weise die ihnen zuzuordnenden Kompensationsspulen $19_j$ jeweils eine durch gestrichelte Linien angedeutete Spulengruppe bilden. Die entsprechenden Gruppen der Detektionsspulen sind in der Figur mit $D_1$ bis $D_4$, die zugehörigen Kompensationsspulengruppen mit $K_1$ bis $K_4$ bezeichnet. Die Zusammenfassung der in diesen Gruppen registrierten Signale wird dabei zweckmäßig mit Hilfe der nachgeschalteten, in der Figur nicht ausgeführten Elektronik vorgenommen.

Bei dem in Fig. 2 angenommenen Ausführungsbeispiel sind aus den Detektionsspulen $17_j$ und den Kompensationsspulen $19_j$ Gruppen $D_1$ bis $D_4$ bzw. $K_1$ bis $K_4$ so gebildet, daß jede der Spulen $17_j$ und $19_j$ nur einer einzigen Gruppe zugeordnet ist. Insbesondere zur Erhöhung der Anpassungsmöglichkeiten an die geometrische Lage der einzelnen Feldquellen kann man jedoch ebensogut einzelne der Spulen auch mehreren Gruppen zuordnen. D.h., die in der Figur durch gestrichelte Linien angedeuteten Gruppen überlappen sich dann hinsichtlich ihrer gemeinsamen Spulen. Es können sich so auch Gruppen mit unterschiedlicher Anzahl ihrer Spulen ergeben.

Abweichend von der planaren Ausführungsform der Trägerstruktur 15 nach Figur 2 können auch Trägerstrukturen mit ausgeprägt dreidimensionaler Gestalt vorgesehen werden, um so die Anordnung von Detektionsspulenreihen und Kopplungsspulenreihen in getrennten parallelen Ebenen zu ermöglichen. Auf diese Weise lassen sich Gradiometer höherer Ordnung erstellen.

**Patentansprüche**

1. Mehrkanalige Vorrichtung zur Messung von verschiedenen Feldquellen hervorgerufener, sich ändernder Magnetfelder mit Feldstärken unter $10^{-10}$ T, insbesondere unter $10^{-12}$ T, wobei die Meßvorrichtung in jedem Kanal ein supraleitendes Quanten-Interferenz-Element (SQUID), ein durch supraleitende Spulen vorbestimmter Abmessungen gebildetes Gradiometer sowie supraleitende Verknüpfungsglieder zwischen dem Quanten-Interferenz-Element und dem Gradiometer enthält, und welche ferner mit elektronischen Einrichtungen zur Auswertung, Verarbeitung und Darstellung der an den Quanten-Interferenz-Elementen gewonnenen Informationen versehen ist, dadurch gekennzeichnet, daß die Abmessungen (Durchmesser d) der einzelnen Gradiometer-Spulen ($2_j$; $17_j$, $19_j$) der Entfernung der nächstliegenden Magnetfeldquelle angepaßt sind und daß Mittel zur Zusammenfassung der Signale einzelner vorbestimmter Gradiometer-Spulen zu jeweils einem Signal einer entsprechenden Gruppe ($D_1$ bis $D_4$; $K_1$ bis $K_4$) von Gradiometer-Spulen in Abhängigkeit von der Entfernung der jeweils zu detektierenden Magnetfeldquelle vorgesehen sind.

2. Meßvorrichtung nach Anspruch 1, dadurch gekennzeichnet, daß zur Zusammenfassung der Signale einzelner Gradiometer-Spulen ($2_j$; $17_j$, $9_j$) die entsprechenden Kanäle in der elektronischen Einrichtung (8) zur Auswertung und Verarbeitung der an den Quanten-Interferenz-Elementen (3) gewonnenen Informationen zusammengeschaltet sind.

3. Meßvorrichtung nach Anspruch 1 oder 2, gekennzeichnet durch eine gemeinsame starre Trägerstruktur (11, 15) für die Quanten-Interferenz-Elemente (3), die ihnen zugeordneten Gradiometer-Spulen ($2_j$; $17_j$, $19_j$) und die supraleitenden Verknüpfungsglieder (5; 20).

4. Meßvorrichtung nach einem der Ansprüche 1 bis 3, dadurch gekennzeichnet, daß die Gradiometer-Spulen als eine Reihe (16) von Detektionsspulen ($17_j$) und als eine Reihe (18) von Kompensationsspulen ($19_j$) auf der gemeinsamen Trägerstruktur (15) angeordnet sind.

5. Meßvorrichtung nach einem der Ansprüche 1 bis 4, dadurch gekennzeichnet, daß die Gradiometer-Spulen ($2_j$; $17_j$, $19_j$) und die supraleitenden Verknüpfungsglieder (5, 20) als Dünnfilm-Strukturen auf der Trägerstruktur (11, 15) aufgebracht sind.

6. Meßvorrichtung nach einem der Ansprüche 1 bis 5, dadurch gekennzeichnet, daß die Quanten-Interferenz-Elemente (3) auf einem gemeinsamen Trägerplättchen (Chip 12, 22) angeordnet sind und dieses Trägerplättchen auf der Trägerstruktur (11, 15) starr befestigt ist.

**Claims**

1. A multi-channel device for measuring changing magnetic fields generated by different field sources with field strengths of under $10^{-10}$ T, in particular under $10^{-12}$T, in which measuring device each channel comprises a superconductive quantum interference element (SQUID), a gradiometer formed by superconductive coils of predetermined dimensions, and superconductive connecting elements between the quantum interference element and the gradiometer, said measuring device being further provided with electronic units for analysing, processing and representig the information obtained on the quantum interference elements, characterised in that the dimensions (diameter d) of the individual gradiometer coils ($2_j$; $17_j$; $19_j$) are adapted to the distance of the nearest magnetic field source and that means are provided for combining the signals of individual predetermined gradiometer coils to form one respective signal for a corresponding group ($D_1$ to $D_4$; $K_1$ to $K_4$) of gradiometer coils in dependence upon the distance of the magnetic field source respectively to be detected.

2. A measuring device as claimed in Claim 1, characterised in that to combine the signals of individual gradiometer coils ($2_j$; $17_j$; $19_j$) the corresponding channels are combined in the electronic units (8) for analysing and processing the information obtained on the quantum interference elements (3).

3. A measuring device as claimed in Claim 1 or 2, characterised by a common rigid carrier structure (11, 15) for the quantum interference elements (3), the gradiometer coils ($2_j$; $17_j$; $19_j$) assigned thereto, and the superconductive connecting elements (5; 20).

4. A measuring device as claimed in one of Claims 1 to 3 characterised in that the gradiometer coils are arranged on the common carrier structure (15) as an array (16) of detection coils ($17_j$) and an array (18) of compensation coils ($19_j$).

5. A measusing device as claimed in one of Claims 1 to 4, characterised in that the gradiometer coils ($2_j$; $17_j$; $19_j$) and the superconductive connecting elements (5, 20) are applied to the carrier structure (11, 15) as thin-film structures.

6. A measuring device as claimed in one of Claims 1 to 5, characterised in that the quantum interference elements (3) are arranged on a common carrier plate (chip 12, 22), and said carrier plate is rigidly fixed on the carrier structure (11, 15).

(11, 15).

## Revendications

1. Dispositif à plusieurs canaux pour la mesure de champs magnétiques variables, engendrés par différentes sources de champs, ayant des intensités de champ inférieures $10^{-10}$ T, en particulier inférieures à $10^{-12}$ T, qui comprend, dans chaque canal, un élément d'interférence quantique supraconducteur (SQUID), un gradiomètre, formé par des bobines supraconductrices de dimensions prédéterminées, ainsi que des éléments de liaison supraconducteurs entre l'élément d'interférence quantique et le gradiomètre, et qui est pourvu, en outre, de dispositifs électroniques pour l'exploitation, le traitement et la représentation des informations obtenues sur les éléments d'interférence quantique, caractérisé en ce que les dimensions (diamètre d) des différentes bobines de gradiomètre $(2_j; 17_j; 19_j)$ sont adaptées à l'éloignement de la source de champ magnétique la plus proche et que des moyens sont prévus pour réunir les signaux de différentes bobines de gradiomètre prédéterminées en un signal d'un groupe correspondant $(D_1$ à $D_4; K_1$ à $K_4)$ de bobines de gradiomètre, en fonction de l'éloignement de la source de champ magnétique à détecter.

2. Dispositif selon la revendication 1, caractérisé en ce que, pour la réunion des signaux des différentes bobines de gradiomètre $(2_j; 17_j, 19_j)$, les canaux correspondants sont connectés ensemble dans le dispositif électronique (8) pour l'exploitation et le traitement des informations obtenues sur les éléments d'interférence quantique (3).

3. Dispositif selon la revendication 1 ou 2, caractérisé par une structure de support rigide (11, 15) commune pour les éléments d'interférence quantique (3), les bobines de gradiomètre $(2_j; 17_j, 19_j)$ qui leur sont coordonnées et les éléments de liaison supraconducteurs (5; 20).

4. Dispositif selon une des revendications 1 à 3, caractérisé en ce que les bobines de gradiomètre sont disposées sur la structure de support commune (15) sous forme d'une série (16) de bobines de détection $(17_j)$ et d'une série (18) de bobines de compensation $(19_j)$.

5. Dispositif selon une des revendications 1 à 4, caractérisé en ce que les bobines de gradiomètre $(2_j; 17_j, 19_j)$ et les éléments de liaison supraconducteurs (5, 20) sont appliqués sur la structure de support (11, 15) sous forme de structures à couche mince.

6. Dispositif selon une des revendications 1 à 5, caractérisé en ce que les éléments d'interférence quantique (3) sont disposés sur une plaquette de support (puce 12, 22) commune et cette plaquette est fixée rigidement sur la structure de support

**FIG 1**

**FIG 2**